# EUROPÄISCHE PATENTSCHRIFT

(11) **EP 2 587 901 B1**
(45) Veröffentlichungstag und Bekanntmachung des Hinweises auf die Patenterteilung: **27.03.2019**
(21) Anmeldenummer: 12006276.5
(22) Anmeldetag: 06.09.2012
(51) Int. Cl.: H05K 5/00, H05K 5/02, B65D 43/02, B65D 43/16, B65D 45/20

(54) **GEHÄUSE MIT EINEM UNTERTEIL UND EINEM DECKEL**
HOUSING WITH A BOTTOM SECTION AND A COVER
BOÎTIER AVEC UNE PARTIE INFÉRIEURE ET UN COUVERCLE

(30) Priorität: 24.10.2011 DE 102011116696
(43) Veröffentlichungstag der Anmeldung: 01.05.2013
(73) Patentinhaber: bopla Gehäuse Systeme GmbH, 32257 Bünde (DE)
(72) Erfinder: Krömer, Andreas, 32425 Minden (DE); Härtel, Klaus, 33739 Bielefeld (DE)
(74) Vertreter: Weeg, Thomas

(56) Entgegenhaltungen:
- EP-A2- 2 317 832
- JP-A- 2004 136 941
- US-A- 5 125 697

## Beschreibung

Die vorliegende Erfindung bezieht sich auf ein Gehäuse mit einem Unterteil und einem Deckel, wobei zumindest ein Spannelement es ermöglicht, wahlweise die Verbindung des Deckels mit dem Unterteil vollständig zu lösen oder das Spannelement als Scharnier zwischen dem Deckel und dem Unterteil zu nutzen.

Ein gattungsgemäßes Gehäuse ist aus der Schrift DE 44 05 947 C1 bekannt. Dort ist eine Spannklammer als Spannelement mit einem an einem Ende der Spannklammer angebrachten Gelenk offenbart. Durch die Spannklammer ist es möglich, die Verbindung des Deckels mit dem Unterteil vollständig zu lösen, indem die Spannklammer entfernt wird, oder auf einer Seite des Gehäuses die Spannklammer in der Einbauposition zu belassen, so dass der Deckel zum Unterteil scharnierartig beweglich ist. Die Spannklammer selbst ist jedoch aus mehreren Teilen zusammengesetzt und deshalb aufwendig in der Herstellung.

Weitere Ausführungen von Gehäusen finden sich in den Schriften EP 2 317 832A2, JP 2004 136941 und US 5 125 697 A.

Es ist die Aufgabe der vorliegenden Erfindung, das gattungsgemäße Gehäuse zu verbessern, indem das Spannelement wesentlich einfacher gestaltet wird.

Die Aufgabe wird für ein gattungsgemäßes Gehäuse durch die Merkmale des Anspruchs 1 gelöst.

Das Spannelement wird in seiner Konstruktion insoweit vereinfacht, als die aus dem Stand der Technik bekannte Spannklammer mit dem mehrteiligen Gelenk ersetzt wird durch ein einziges Formteil, das aufgrund seiner besonderen Ausgestaltung in der verrasteten Position den Deckel mit dem Unterteil fest verbindet, durch seine Elastizität aber durch einen einfachen Fingerdruck oder als alternative Ausgestaltung nur durch ein Werkzeug aus der verrasteten Position gelöst werden kann und so der Deckel wieder abnehmbar ist, wobei das Spannelement in seiner verrasteten Position aber auch eine scharnierartige Verschwenkung des Deckels ermöglicht, wenn der Deckel auf den übrigen Seiten des Gehäuses nicht mit dem Unterteil verbunden ist.

Das erfindungsgemäße Spannelement ist kostengünstig herstellbar und bei der Montage des Gehäuses leicht handhabbar. Die Gehäusemontage wird durch das einteilige Spannelement vereinfacht und beschleunigt.

Der Materialaufwand für das Spannelement selbst sinkt ebenfalls, so dass das erfindungsgemäße Gehäuse insgesamt kostengünstiger ist. Das Gehäuse kann sortenrein in einem einzigen Kunststoff hergestellt werden, was Vorteile bei der späteren Entsorgung bringt.

Zudem kann das komplette Gehäuse aus nur 4 Teilen - dem Unterteil, dem Deckel und dem Verschluss durch zwei an gegenüberliegenden Stellen angebrachten Spannelementen - fest verschlossen hergestellt werden. Dadurch wird auch die Teiledisposition und -logistik in der Fertigung vereinfacht.

Dadurch, dass das Spannelement in der verrasteten Position einer Zugspannung ausgesetzt ist, bleiben der Deckel und das Unterteil fest aufeinander gehalten, ohne dass sich das eine Bauteil relativ zum anderen Bauteil bewegen kann. Die Zugspannung entsteht, indem das Abstandsmaß des Spannelements in seinem entspannten Zustand zwischen der die feststehende Achse teilweise umgreifenden Lasche und der die formschlüssige Rastverbindung bildenden Rastnase das Abstandsmaß zwischen der am ersten Gehäusebauteil ausgebildeten Rastkante der formschlüssigen Rastverbindung bis zur von der Rastkante weg weisenden Oberfläche der feststehenden Achse knapp unterschreitet und das Spannelement deshalb in der verrasteten Position im Verhältnis zu seiner Form in einem entspannten Zustand leicht aufgeweitet und elastisch verformt ist und die Rückstellkräfte, die das Spannelement durch die Verformung aufbaut, als Zugspannung auf die Gehäusebauteile einwirken. Durch die Zugspannung werden Klappergeräusche vermieden, die bei einer Bewegung des Gehäuses durch ein Spiel zwischen den Bauteilen auftreten können. Wenn die Trennstellen zwischen dem Deckel und dem Unterteil mit einer Dichtung versehen sind, ist das Gehäuse zumindest ausreichend dicht gegen Spritzwasser, Schmutz und Staub. Durch die feste Verbindung des Deckels mit dem Unterteil macht das Gehäuse einen insgesamt sehr stabilen und wertigen Eindruck.

Nach einer Ausgestaltung der Erfindung ist das Spannelement als eine um die feststehende Achse verschwenkbare Abdeckleiste ausgebildet, die sich über mehr als die Hälfte der Seitenlänge der Gehäuseseite erstreckt, an der sie angebracht ist, die Abdeckleiste überdeckt den Gehäuserand in einem Bereich von der am zweiten Gehäusebauteil ausgebildeten feststehenden Achse bis zur Rastkante des ersten Gehäusebauteils und unter der Abdeckleiste sind am ersten und/oder zweiten Gehäusebauteil Verschraubungsbereiche, Versteifungsrippen, Auflageflächen, Nuten, Federn und/oder Abdecknasen ausgebildet. Durch die Ausbildung als Abdeckleiste können die optisch unruhigen Elemente der Verbindungstechnik in der verrasteten Position vom Spannelement verdeckt werden, das Spannelement übernimmt somit neben seiner Fixierungsfunktion zusätzlich auch eine Designfunktion, soweit es gelingt, unter der Abdeckleiste Gehäusetechnik optisch zu verstecken.

Nach einer Ausgestaltung der Erfindung ist das Spannelement als ein klammerartiges Profil mit einer geschlossenen nach außen weisenden Oberfläche ausgebildet, das einen Kantenbereich des Gehäuses zwischen der feststehenden Achse und der Rastkante übergreift. Durch die geschlossene und vorzugsweise glatt ausgeführte nach außen weisende Oberfläche ergibt sich eine ansprechende Optik des gesamten Gehäuses. Die unebenen Oberflächen der Verbindungstechnik werden unter der Oberfläche verborgen und sind in der verrasteten Position des Spannelements nicht sichtbar. Gerade der optisch den Gesamteindruck stark beeinflussende Kantenbereich des Gehäuses kann dadurch mit glatten Oberflächen und einer zum übrigen Gehäusedesign passenden Kantenausbildung versehen sein, beispielsweise mit einer scharfen oder verrundeten Kante und flachen Schenkeln, deren Lage an die angrenzenden Oberflächen der Gehäusebauteile angepasst ist.

Nach einer Ausgestaltung der Erfindung sind am zweiten Gehäusebauteil auf der Seite, auf der das Spannelement angeordnet ist, zumindest zwei beabstandet zueinander angeordnete feststehende Achsen angeordnet. Durch die Anordnung von zumindest zwei beabstandet zueinander angeordneten feststehenden Achsen kann die Zugspannung breiter über die Seitenwandung des Gehäusebauteils verteilt und in diese eingeleitet werden.

Nach einer Ausgestaltung der Erfindung erstreckt sich die feststehende Achse oder Achsen und die formschlüssige Rastverbindung nur über einen Teil der Seitenlänge des Spannelements. Dadurch, dass sich die feststehende oder feststehenden Achsen nicht über die volle Seitenlänge des Spannelements erstrecken, bleiben im Spannelement und/oder den benachbarten Gehäusebauteilen noch ausreichend Platz übrig, um dort Versteifungsrippen, Verschraubungsbereiche, Auflageflächen, Nuten und Federn und dergleichen ausbilden zu können. Auch über feststehende Achsen, die sich nur über einen Teil der Seitenlänge des Spannelements erstrecken, können bereits erhebliche und ausreichende Zugspannungen aufgebaut werden, mit denen der Deckel auf dem Unterteil des Gehäuses gehalten ist.

Nach einer Ausgestaltung der Erfindung sind die Stützflächen, über die sich das erste Gehäusebauteil auf der feststehenden Achse abstützt, an Versteifungsrippen ausgebildet, die auf ihrer dem Spannelement zugewandten Seite Auflageflächen aufweisen, die in der verrasteten Position des Spannelements an Innenoberflächen des Spannelements anliegen. Die Versteifungsrippen können vergleichsweise schmal ausgebildet werden, da sie schon bei einer Materialdicke einer massiven Versteifungsrippe von beispielsweise 1 mm erhebliche Stützkräfte übertragen können. Bei der Verwendung mehrerer Versteifungsrippen addieren sich die Stützkräfte zu Werten auf, die die beim üblichen Gebrauch einwirkenden Belastungen übersteigen. Durch die Ausbildung von Versteifungsrippen kann Material eingespart werden, und der Bauraum, in dem keine Versteifungsrippen vorhanden sind, kann für andere Funktionselemente genutzt werden.

Nach einer Ausgestaltung der Erfindung sind an dem Spannelement Versteifungsrippen ausgebildet, die auf ihrer dem ersten und/oder dem zweiten Gehäusebauteil zugewandten Seite Auflageflächen aufweisen, die in der verrasteten Position des Spannelements an Oberflächen des ersten und/oder zweiten Gehäusebauteils anliegen. Durch die Versteifungsrippen wird das Spannelement in seiner Einbaulage abgestützt und in seiner Form stabilisiert. Durch die Versteifungsrippen erhält das Spannelement in seiner Einbaulage in der verrasteten Position eine hohe Steifigkeit, durch die das Gehäuse insgesamt einen sehr guten Qualitätseindruck macht. Zudem werden über die Versteifungsrippen die auf das Spannelement und die Gehäusebauteile einwirkenden Kräfte gleichmäßiger über die Bauteillänge und -breite verteilt. Da das Spannelement in der verrasteten Position einer Zugspannung ausgesetzt ist, könnte sich das Material des Spannelements auf Dauer gesehen verformen, insbesondere bei polymeren Werkstoffen. Dabei könnte die Zugspannung nachlassen, was sich nachteilig auf die Verbindung des Unterteils mit dem Deckel auswirken könnte. Durch die Abstützung kann also auf Dauer die Zugspannung erhalten bleiben.

Nach einer Ausgestaltung der Erfindung weisen das erste und zweite Gehäusebauteil in ihrem Anstoßbereich eine Nut-/ Federverbindung auf. Durch eine Nut-/ Federverbindung kann eine gute Abdichtung des Innenraums des Gehäuses nach außen erzielt werden. Um die Dichtigkeit zu steigern, kann in die Nut-/ Federverbindung zusätzlich noch eine flexible Dichtung eingelegt sein, durch die sich die Dichtigkeit des Gehäuses erhöht.

Nach einer Ausgestaltung der Erfindung ist das komplette Gehäuse nur aus dem Deckel, dem Unterteil und einem oder zwei einteilig ausgestalteten Spannelementen gebildet. Durch die nur drei oder vier Bauteile, die das komplette Gehäuse bilden, wird die Vorratshaltung, Logistik und die Montage vereinfacht. Auch hierdurch ist das Gehäuse insgesamt sehr kostengünstig herstellbar.

Es wird ausdrücklich darauf hingewiesen, dass die Merkmale der vorstehend erläuterten Ausgestaltungen der Erfindung jeweils für sich und in Kombination mit den Merkmalen der anderen beschriebenen Ausgestaltungen mit dem Gegenstand des Hauptanspruches kombinierbar sind, soweit dies nicht durch technische Zwänge ausgeschlossen ist.

Weitere Abwandlungen und Ausgestaltungen der Erfindung lassen sich der nachfolgenden gegenständlichen Beschreibung und den Zeichnungen entnehmen.

Die Erfindung soll nun anhand eines Ausführungsbeispiels näher beschrieben werden. Es zeigen:
- Fig. 1:: eine Querschnittsansicht durch ein Gehäuse,
- Fig. 2:: die Querschnittsansicht aus Fig. 1 mit ausgeklapptem Deckel, und
- Fig. 3:: eine Ansicht von oben auf den Randbereich des Gehäuses mit geöffnetem Spannelement.

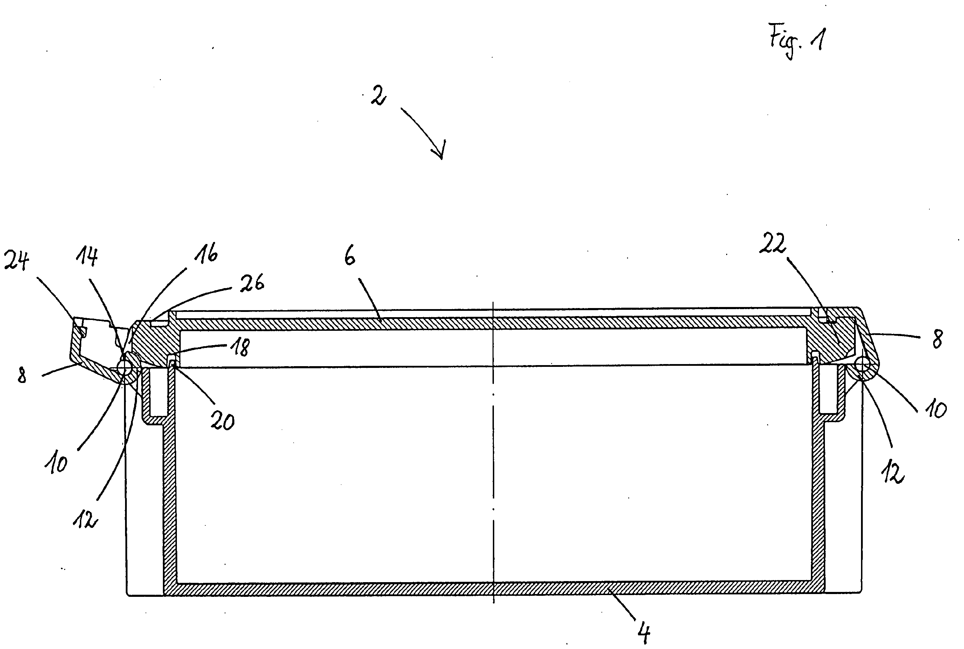

In Fig. 1 ist ein Gehäuse 2 in einer Querschnittsansicht gezeigt. Das Gehäuse 2 ist zusammengesetzt aus dem Unterteil 4, auf das der Deckel 6 aufgesetzt ist. Das Unterteil 4 und der Deckel 6 sind jeweils ein erstes und zweites Gehäusebauteil. Die Gehäusebauteile können über die Spannelemente 8 miteinander verbunden werden. Während in Fig. 1 das rechte Spannelement 8 in einer verrasteten Position dargestellt ist, wird das linke Spannelement 8 in einer geöffneten Stellung gezeigt. Die Spannelemente 8 verfügen über eine Lasche 12, die eine feststehende Achse 10 umgreifen, die fest mit dem Unterteil 4 verbunden ist. Die Lasche 12 kann in einer Schwenkstellung des Spannelements 8 von der feststehenden Achse 10 abgezogen werden, wenn das Spannelement 8 komplett vom entsprechenden Gehäusebauteil 4, 6 entfernt werden soll.

Am Deckel 6 sind Stützflächen 14 ausgebildet, mit denen sich der Deckel 6 auf der jeweiligen feststehenden Achse 10 abstützt. Im Ausführungsbeispiel ist die Stützfläche 14 an einer Versteifungsrippe 16 ausgebildet. Die Stützfläche 14 kann aber auch auf andere Weise an einem Oberflächenabschnitt auf der Unterseite des Deckels 6 ausgebildet sein. Die Stützfläche 14 liegt spielfrei auf der benachbarten Oberfläche der feststehenden Achse 10 auf. Da die Stützfläche 14 der Umfangskontur der feststehenden Achse 10 angepasst ist, ergibt sich im Ausführungsbeispiel im Bereich der Stützfläche 14 eine unebene flächige Anlage der Stützflächen 14 auf der Achse 10 als Verbindung zwischen dem Deckel 6 und dem Unterteil 4. Bei einer scharnierartigen Schwenkbewegung des Deckels 6 um die feststehende Achse 10 herum gleiten die Stützflächen 14 über die Oberfläche der feststehenden Achse 10. Durch die einander entsprechenden unebenen Flächen der Stützfläche 14 und der feststehenden Achse 10 wird eine andere Relativbewegung zwischen dem Unterteil 4 und dem Deckel 6 blockiert, so dass sich eine definierte Schwenkbewegung ergibt.

Außer der Verschwenkbewegung um die feststehende Achse 10 herum kann somit der Deckel 6 nur vom Unterteil 4 abgehoben werden.

Im Ausführungsbeispiel ist am Deckel 6 eine umlaufende Nut 18 vorhanden, in die in der Schließstellung des Deckels 6 die Feder 20, die am Unterteil 4 ausgebildet ist, eintaucht. Durch die Nut-/Federverbindung zwischen dem Unterteil 4 und dem Deckel 6 wird der Innenraum des Gehäuses 2 dichtend abgeschlossen. Um die Abdichtung zusätzlich zu erhöhen, kann in die Nut 18 noch eine gesonderte Dichtung eingelegt sein.

In den Deckelrand 22 ist im Bereich der Spannelemente 8 eine Rastkante 26 eingeformt, die von einer am Spannelement 8 ausgebildeten Rastnase 24 in der verrasteten Position des Spannelementes 8 hintergriffen wird. Die Rastnase 24 und die Rastkante 26 bilden auf diese Weise eine Rastverbindung des Spannelementes 8 mit dem Deckel 6.

Um eine Rastverbindung zwischen dem Spannelement 8 und dem Deckel 6 herzustellen, muss das linke in Fig. 1 gezeigte Spannelement 8 um die feststehende Achse 10 in Pfeilrichtung verschwenkt werden. Um das in Fig. 1 rechte Spannelement 8 zu öffnen, muss es ebenfalls in Pfeilrichtung verschwenkt werden.

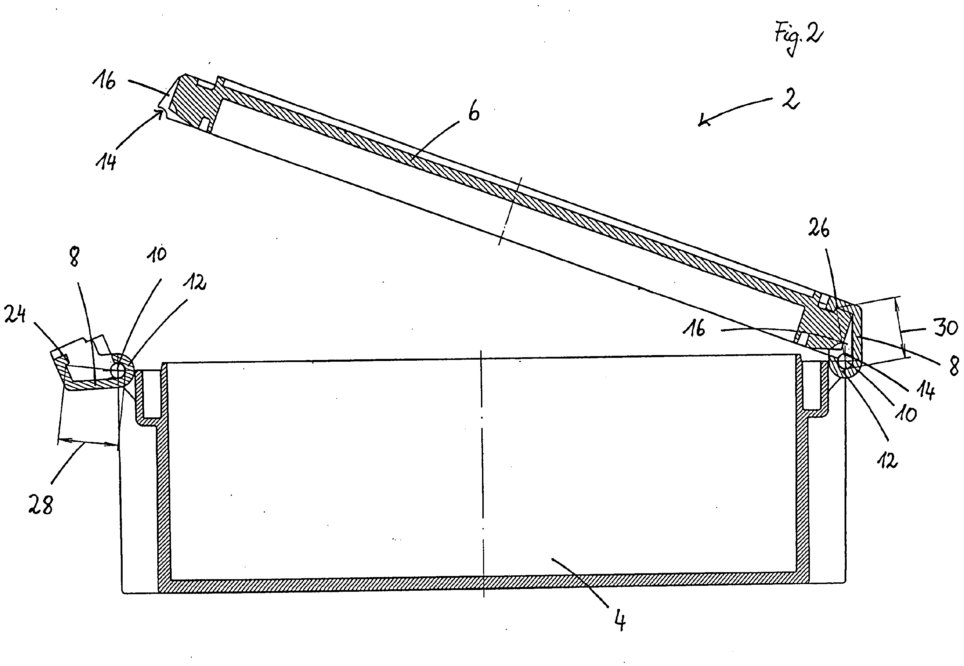

In Fig. 2 ist das Gehäuse 2 mit einem teilweise aufgeschwenkten Deckel 6 gezeigt. Zum Öffnen des Gehäuses 2 ist der Deckel dazu um die rechte feststehende Achse 10 als Scharnierachse verschwenkt worden. In Fig. 2 ist erkennbar, dass das Abstandsmaß 28 zwischen der die feststehende Achse 10 teilweise umgreifenden Lasche 12 und der Rastnase 24 des links in Fig. 2 dargestellten Spannelementes 8 kleiner ist als das Abstandsmaß 30 zwischen der am Deckel 6 ausgebildeten Rastkante 26 bis zu der von der Rastkante 26 weg weisenden Oberfläche der feststehenden Achse 10 bei dem rechts in Fig. 2 abgebildeten Spannelement 8. Um die im rechten Gehäuseteil der Fig. 2 dargestellte verrastete Position einnehmen zu können, muss sich das Spannelement 8 also in seinem Abstandsmaß 28 auf das Abstandsmaß 30 aufweiten. Bei der Aufweitungsbewegung baut das Spannelement 8 durch die Elastizität des verwendeten Materials Rückstellkräfte auf, durch die sich zwischen der Lasche 12 und der Rastnase 24 eine Zugspannung aufbaut. Durch die zwischen der Lasche 12 und der Rastnase 24 wirkende Zugspannung wird der Deckel 6 mit den Stützflächen 14 auf die feststehende Achse 10 gepresst. Auf diese Weise wird der Deckel 6 vom Spannelement 8 über die Stützflächen 14 auf der feststehenden Achse 10 schwenkbar gehalten. Dabei bildet die Innenoberfläche der Lasche 12 zusammen mit den Stützflächen 14 ein Schwenklager auf der feststehenden Achse 10 aus, um das der Deckel 6 verschwenkbar ist.

Im Ausführungsbeispiel ist die feststehende Achse am Unterteil 4 und die Rastkante 26 am Deckel 6 angeordnet, die Anordnung kann jedoch auch umgekehrt ausgebildet sein, wobei dann die Lasche des Spannelement 8 die feststehende Achse am Deckel 6 und die Rastnase 24 die Rastnase am Unterteil 4 umgreift.

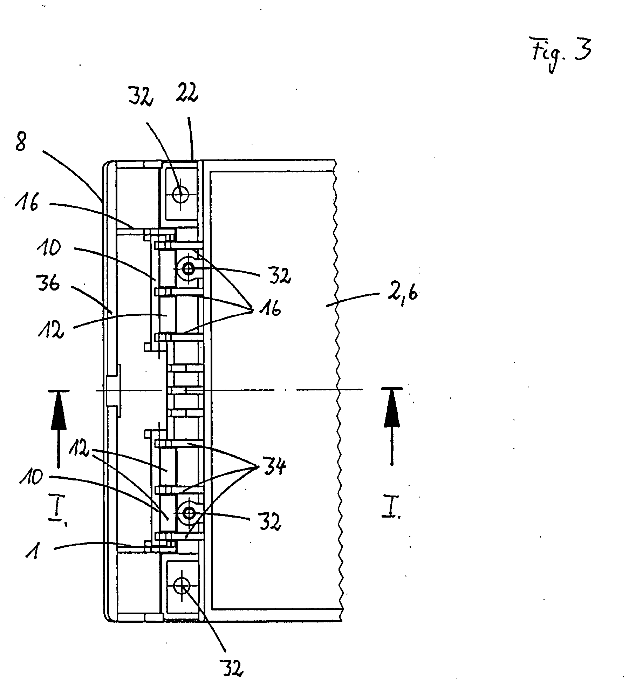

In Fig. 3 ist ein Teil des Gehäuses 2 mit aufgesetztem Deckel 6 aus einer Ansicht von oben gezeigt. Das Spannelement 8 befindet sich in einer aufgeschwenkten Position. Aus der Ansicht von oben ist erkennbar, dass sich im Bereich des Deckelrandes 22 Verschraubungsbereiche 32, Auflageflächen 34 sowie Versteifungsrippen 16 befinden. Die in Fig. 3 angelegte Schnittlinie I-I entspricht im Wesentlichen einem Teil der Schnittansichten gemäß Fig. 1 und Fig. 2. Wird das in Fig. 3 dargestellte Spannelement 8 aus der offenen Schwenkstellung in eine verrastete Position verbracht, verdeckt die Abdeckleiste 36 des Spannelementes 8 die Verschraubungsbereiche 32, die Auflageflächen 34 sowie die Versteifungsrippen 16. Auch die am Spannelement 8 ausgebildeten Versteifungsrippen 16 sind in der verrasteten Position des Spannelementes 8 nicht mehr sichtbar.

Wie aus Fig. 3 ersichtlich ist, erstreckt sich das Spannelement 8 über die gesamte Seitenlänge der Gehäuseseite, an der das Spannelement angebracht ist. Durch diese Länge ist es möglich, im Bereich des Deckelrandes 22 viele Funktionselemente wie Verschraubungsbereiche 32, Auflageflächen 34 und dergleichen unterzubringen und diese in der verrasteten Position des Spannelementes 8 unter der Abdeckleiste 36 zu verstecken. Um eine gute Kraftverteilung zwischen dem Unterteil 4, dem Deckel 6 und dem Spannelement 8 zu erreichen, ist es vorteilhaft, wenn sich das Spannelement 8 über mehr als die Hälfte der Seitenlänge der Gehäuseseite erstreckt, an der es angebracht ist.

Aus der Ansicht von oben sind auch zwei feststehende Achsen 10 erkennbar, die von den zugehörigen Laschen 12 des Spannelementes 8 teilweise umgriffen sind. Die feststehenden Achsen 10 sind nur in einem Teilabschnitt der Seitenwand des Unterteils 4 ausgebildet.

In dem Bereich, in dem die deckelseitigen Versteifungsrippen 16 auf die feststehenden Achsen 10 treffen, sind Stützflächen 14 an den Versteifungsrippen 16 ausgebildet. Aus der Ansicht von oben ist erkennbar, dass im Ausführungsbeispiel insgesamt sechs Stützflächen 14 deckelseitig ausgebildet sind, über die der Deckel 6 in einer passend ausgerichtet Position gegenüber dem Unterteil 4 gehalten wird. Auch an den Versteifungsrippen 16, die auf der Unterseite des Spannelementes 8 ausgebildet sind, können entsprechende Stützflächen 14 ausgebildet sein.

Befindet sich das Spannelement 8 in einer verrasteten Position, liegt die Innenoberfläche der Abdeckleiste 36 auf den Auflageflächen 34 auf. Auf diese Weise ist das Spannelement 8 und die Abdeckleiste 36 in der verrasteten Position gut abgestützt. Entsprechende Auflageflächen können auch auf der Innenoberfläche des Spannelementes 8 oder auf dem am Spannelement 8 ausgebildeten Versteifungsrippen 16 ausgebildet sein.

Die vorstehende gegenständliche Beschreibung der Erfindung dient nur der Erläuterung der Erfindung, die jedoch nicht auf das Ausführungsbeispiel beschränkt ist. Dem Fachmann ist es möglich, das Ausführungsbeispiel auf eine ihm als geeignet erscheinende Weise an einen konkreten Anwendungsfall abzuwandeln und anzupassen.

## Patentansprüche

1. Gehäuse (2) mit einem Unterteil (4) und einem Deckel (6) als einem ersten und zweiten Gehäusebauteil (4, 6), die über ein oder mehrere Spannelemente (8) miteinander verbunden sind, wobei zumindest ein Spannelement (8) es ermöglicht, wahlweise die Verbindung des Deckels mit dem Unterteil vollständig zu lösen oder das Spannelement (8) als Scharnier zwischen dem Deckel und dem Unterteil zu nutzen, wobei
am ersten Gehäusebauteil (4, 6) Stützflächen (14) ausgebildet sind, mit denen sich das erste Gehäusebauteil (4, 6) in einer verrasteten Position des Spannelements (8) auf einer am zweiten Gehäusebauteil (4, 6) ausgebildeten feststehenden Achse (10) abstützt, das Spannelement (8) in seiner verrasteten Position an einer ersten Seite mit der feststehenden Achse (10) mittels einer die feststehende Achse (10) teilweise umgreifenden Lasche (12) verbunden ist, das Spannelement (8) in seiner verrasteten Position auf einer zweiten Seite formschlüssig mit dem ersten Gehäusebauteil (4, 6) verrastet ist und dadurch das erste Gehäusebauteil (4, 6) mit den Stützflächen (14) auf die feststehende Achse (10) gedrückt hält, wobei das Spannelement (8) so geformt ist, dass es in entspanntem Zustand mit dem Abstandsmaß (28) zwischen der die feststehende Achse (10) teilweise umgreifenden Lasche (12) und einer die formschlüssige Rastverbindung bildenden Rastnase (24) das Abstandsmaß (30) zwischen einer am ersten Gehäusebauteil (4, 6) ausgebildeten Rastkante (26) der formschlüssigen Rastverbindung bis zur von der Rastkante (26) weg weisenden Oberfläche der feststehenden Achse (10) unterschreitet und das Material des Spannelements (8) in der verrasteten Position im Verhältnis zu seiner Form in einem entspannten Zustand aufgeweitet und elastisch verformt ist, so dass die Rastnase (24) über die Rastkante (26) hinweg einrastet und seine verrastete Position einnimmt, wobei das Spannelement (8) in der verrasteten Position einer Zugspannung durch Rückstellkräfte, die das Spannelement (8) durch die Verformung aufbaut, ausgesetzt ist, die als Zugspannung auf die Gehäusebauteile (4, 6) einwirken.

2. Gehäuse (2) nach Anspruch 1, **dadurch gekennzeichnet, dass** das Spannelement (8) als eine um die feststehende Achse (10) verschwenkbare Abdeckleiste (36) ausgebildet ist, die sich über mehr als die Hälfte der Seitenlänge der Gehäuseseite erstreckt, an der sie angebracht ist, die Abdeckleiste (36) den Gehäuserand in einem Bereich von der am zweiten Gehäusebauteil (4, 6) ausgebildeten feststehenden Achse (10) bis zur Rastkante (26) des ersten Gehäusebauteils (4, 6) überdeckt und unter der Abdeckleiste (36) am ersten und/oder zweiten Gehäusebauteil (4, 6) Verschraubungsbereiche (32), Versteifungsrippen (16), Auflageflächen (34), Nuten (18), Federn (20) und/oder Abdecknasen ausgebildet sind.

3. Gehäuse (2) nach einem der vorhergehenden Ansprüche, **dadurch gekennzeichnet, dass** das Spannelement (8) als ein klammerartiges Profil mit einer geschlossenen nach außen weisenden Oberfläche ausgebildet ist, das einen Kantenbereich des Gehäuses (2) zwischen der feststehenden Achse (10) und der Rastkante (26) übergreift.

4. Gehäuse (2) nach einem der vorhergehenden Ansprüche, **dadurch gekennzeichnet, dass** am zweiten Gehäusebauteil (4, 6) auf der Seite, auf der das Spannelement (8) angeordnet ist, zumindest zwei beabstandet zueinander angeordnete feststehende Achsen (10) angeordnet sind.

5. Gehäuse (2) nach einem der vorhergehenden Ansprüche, **dadurch gekennzeichnet, dass** sich die feststehende Achse (10) oder die feststehenden Achsen (10) und die formschlüssige Rastverbindung nur über einen Teil der Seitenlänge des Spannelements (8) erstreckt.

6. Gehäuse (2) nach einem der vorhergehenden Ansprüche, **dadurch gekennzeichnet, dass** die Stützflächen (14), über die sich das erste Gehäusebauteil (4, 6) auf der feststehenden Achse (10) abstützt, an Versteifungsrippen (16) ausgebildet sind, die auf ihrer dem Spannelement (8) zugewandten Seite Auflageflächen (34) aufweisen, die in der verrasteten Position des Spannelements (8) an Innenoberflächen des Spannelements (8) anliegen.

7. Gehäuse (2) nach einem der vorhergehenden Ansprüche, **dadurch gekennzeichnet, dass** an dem Spannelement (8) Versteifungsrippen (16) ausgebildet sind, die auf ihrer dem ersten und/oder dem zweiten Gehäusebauteil (4, 6) zugewandten Seite Auflageflächen (34) aufweisen, die in der verrasteten Position des Spannelements (8) an Oberflächen des ersten und/oder zweiten Gehäusebauteils (4, 6) anliegen.

8. Gehäuse (2) nach einem der vorhergehenden Ansprüche, **dadurch gekennzeichnet, dass** das erste und zweite Gehäusebauteil (4, 6) in ihrem Anstoßbereich eine Nut-/ Federverbindung (18, 20) aufweisen.

9. Gehäuse (2) nach einem der vorhergehenden Ansprüche, **dadurch gekennzeichnet, dass** das komplette Gehäuse (2) nur aus dem Deckel (6), dem Unterteil (4) und einem oder zwei einteilig ausgestalteten Spannelementen (8) gebildet ist.

## Claims

1. Housing (2) comprising a bottom part (4) and a top (6) as a first and second housing component (4, 6), which are interconnected by one or more clamping elements (8), wherein at least one clamping element (8) makes it possible either to completely detach the connection between the top and the bottom part or to use the clamping part (8) as a hinge between the top and the bottom part, wherein support surfaces (14) are formed on the first housing component (4, 6) by means of which the first housing component (4, 6), in an engaged position of the clamping element (8), is supported on a stationary shaft (10) formed on the second housing component (4, 6), the clamping element (8), in its engaged position, is connected on a first side to the stationary shaft (10) by means of a tab (12) which partly surrounds the stationary shaft (10), the clamping element (8), in its engaged position, interlockingly engages on a second side with the first housing component (4, 6) and thus holds down the first housing component (4, 6) having the support surfaces (14) on the stationary shaft (10), wherein the clamping element (8) is formed such that, in a relaxed state with the distance measure (28) between the tab (12) partly surrounding the stationary shaft (10) and a latching lug (24) that forms the interlocking latching connection, it falls short of the distance measure (30) between a latching edge (26), formed on the first housing component (4, 6), of the interlocking latching connection as far as the surface of the stationary shaft (10) facing away from the latching edge (26), and the material of the clamping element (8) is expanded and elastically deformed in the engaged position compared with its shape in a relaxed state such that the latching lug (24) engages beyond the latching edge (26) and assumes its engaged position, wherein the clamping element (8) is subjected to tensile stress in the engaged position on account of restoring forces which are built up by the clamping element (8) as a result of the deformation and which act on the housing components (4, 6) as tensile stress.

2. Housing (2) according to claim 1, **characterised in that** the clamping element (8) is designed as a cover strip (36) that can pivot about the stationary shaft (10) and extends over more than half the side length of the housing side to which it is attached, the cover strip (36) covers the housing edge in a region from the stationary shaft (10) formed on the second housing component (4, 6) as far as the latching edge (26) of the first housing component (4, 6), and screwing regions (32), reinforcing ribs (16), bearing surfaces (34), grooves (18), tongues (20) and/or cover lugs being formed beneath the cover strip (36) on the first and/or second housing component (4, 6).

3. Housing (2) according to either of the preceding claims, **characterised in that** the clamping element (8) is a designed as a bracket-like profile which has a closed, outward-facing surface and overlaps an edge region of the housing (2) between the stationary shaft (10) and the latching lug (26).

4. Housing (2) according to any of the preceding claims, **characterised in that** at least two mutually spaced stationary shafts (10) are arranged on the second housing component (4, 6) on the side on which the clamping element (8) is arranged.

5. Housing (2) according to any of the preceding claims, **characterised in that** the stationary shaft (10) or the stationary shafts (10) and the interlocking latching connection extends only over part of the side length of the clamping element (8).

6. Housing (2) according to any of the preceding claims, **characterised in that** the support surfaces (14), by means of which the first housing component (4, 6) is supported on the stationary shaft (10), are formed on reinforcing ribs (16) which, on their sides facing the clamping element (8), have bearing surfaces (34) that abut inner surfaces of the clamping element (8) in the engaged position of the clamping element (8).

7. Housing (2) according to any of the preceding claims, **characterised in that** reinforcing ribs (16) are formed on the clamping element (8) which, on their sides facing the first and/or the second housing component (4, 6), have bearing surfaces (34) that abut surfaces of the first and/or second housing component (4, 6) in the engaged position of the clamping element (8).

8. Housing (2) according to any of the preceding claims, **characterised in that** the first and second housing component (4, 6) have a tongue-and-groove connection (18, 20) in the abutment region thereof.

9. Housing (2) according to any of the preceding claims, **characterised in that** the entire housing (2) is made up of only the top (6), the bottom part (4) and one or two one-piece clamping elements (8).

## Revendications

1. Boîtier (2) avec une partie inférieure (4) et un couvercle (6) comme premier et deuxième composants de boîtier (4, 6) reliés par un ou plusieurs éléments de serrage (8), dans lequel au moins un élément de serrage (8) permet au choix de desserrer complètement la connexion du couvercle à la partie inférieure ou d'utiliser l'élément de serrage (8) à la manière d'une charnière entre le couvercle et la partie inférieure, dans lequel des surfaces d'appui (14) sont réalisées sur le premier composant de boîtier (4, 6) par lesquelles le premier composant de boîtier (4, 6), dans une position encliquetée de l'élément de serrage (8), prend appui sur un axe fixe (10) réalisé sur le deuxième composant de boîtier (4, 6), l'élément de serrage (8), dans sa position encliquetée sur un premier côté, est relié à l'axe fixe (10) au moyen d'une patte (12) entourant partiellement l'axe fixe (10), l'élément de serrage (8), dans sa position encliquetée sur un deuxième côté, est encliqueté par complémentarité de forme avec le premier composant de boîtier (4, 6) maintenant ainsi le premier composant de boîtier (4, 6) appuyé sur l'axe fixe (10) par les surfaces d'appui (14), dans lequel l'élément de serrage (8) est formé de telle sorte qu'à l'état détendu il soupasse par la mesure d'écart (28) entre la patte (12) entourant partiellement l'axe fixe (10) et un bec d'encliquetage (24) formant l'assemblage par encliquetage par complémentarité de forme la mesure d'écart (30) entre un bord d'encliquetage (26), réalisé sur le premier composant de boîtier (4, 6), de l'assemblage par encliquetage par complémentarité de forme jusqu'à la surface, détournée du bord d'encliquetage (26), de l'axe fixe (10), et le matériau de l'élément de serrage (8) dans la position encliquetée est évasé et déformé de manière élastique par rapport à sa forme dans un état détendu, de sorte que le bec d'encliquetage (24) vient s'encliqueter au-delà du bord d'encliquetage (26) et adopte sa position encliquetée, dans lequel l'élément de serrage (8) dans la position encliquetée est soumis à un effort de traction dû à des forces de rappel produites par l'élément de serrage (8) en raison de la déformation et agissant comme un effort de traction sur les composants de boîtier (4, 6).

2. Boîtier (2) selon la revendication 1, **caractérisé en ce que** l'élément de serrage (8) est réalisé comme une baguette de recouvrement (36) pivotante autour de l'axe fixe (10) et s'étendant sur plus de la moitié de la longueur latérale de la face de boîtier à laquelle elle est rattachée, **en ce que** la baguette de recouvrement (36) recouvre le bord de boîtier dans une zone allant de l'axe fixe (10) réalisé sur le deuxième composant de boîtier (4, 6) jusqu'au bord d'encliquetage (26) du premier composant de boîtier (4, 6), et **en ce que** des zones de vissage (32), des nervures de renforcement (16), des surfaces d'appui (34), des rainures (18), des languettes (20) et/ou des becs de recouvrement sont réalisé sous la baguette de recouvrement (36) sur le premier et/ou le deuxième composant de boîtier (4, 6).

3. Boîtier (2) selon l'une quelconque des revendications précédentes, **caractérisé en ce que** l'élément de serrage (8) est réalisé sous la forme d'un profilé de type bride avec une surface fermée tournée vers l'extérieur, ledit profilé chevauchant une zone de bord du boîtier (2) entre l'axe fixe (10) et le bord d'encliquetage (26).

4. Boîtier (2) selon l'une quelconque des revendications précédentes, **caractérisé en ce que** sur le deuxième composant de boîtier (4, 6), sur le côté où est disposé l'élément de serrage (8) sont disposés au moins deux axes fixes (10) disposés en étant espacés l'un par rapport à l'autre.

5. Boîtier selon l'une quelconque des revendications précédentes, **caractérisé en ce que** l'axe fixe (10) ou les axes fixes (10) et l'assemblage par encliquetage par complémentarité de forme ne s'étend(ent) que sur une partie de la longueur latérale de l'élément de serrage.

6. Boîtier (2) selon l'une quelconque des revendications précédentes, **caractérisé en ce que** les surfaces d'appui (14) par lesquelles le premier composant de boîtier (4, 6) prend appui sur l'axe fixe (10) sont réalisées sur des nervures de renforcement (16) qui présentent sur leur face tournée vers l'élément de serrage (8) des surfaces d'appui (34) en butée contre des surfaces intérieures de l'élément de serrage (8) dans la position encliquetée de l'élément de serrage (8).

7. Boîtier (2) selon l'une quelconque des revendications précédentes, **caractérisé en ce que** des nervures de renforcement (16) sont réalisées sur l'élément de serrage qui présentent sur leur face tournée vers le premier et/ou le deuxième composant de boîtier (4, 6) des surfaces d'appui (34) en butée contre des surfaces du premier et/ou du deuxième composant de boîtier (4, 6) dans la position encliquetée de l'élément de serrage (8).

8. Boîtier (2) selon l'une quelconque des revendications précédentes, **caractérisé en ce que** les premier et deuxième composants de boîtier (4, 6) présentent un assemblage à rainure et languette (18, 20) dans la zone de contact.

9. Boîtier (2) selon l'une quelconque des revendications précédentes, **caractérisé en ce que** le boîtier complet (2) n'est composé que du couvercle (6), de la partie inférieure (4) et d'un ou de deux éléments de serrage (8) réalisés d'une seule pièce.
